# EUROPEAN PATENT APPLICATION

(11) **EP 4 514 099 A1**
(43) Date of publication of application: **26.02.2025**
(21) Application number: 23767021.1
(22) Date of filing: 06.02.2023
(51) Int. Cl.: H10K 30/10, H10K 30/30, H10K 30/80

(54) **PEROVSKITE SOLAR CELL AND MANUFACTURING METHOD THEREFOR**

(30) Priority: 07.03.2022 KR 20220028853
(71) Applicant: Hanwha Solutions Corporation, Jung-gu Seoul 04541 (KR)
(72) Inventor: BACK, HyungCheol, Seongnam-si, Gyeonggi-do 13488 (KR); KIM, Geun Jin, Seongnam-si, Gyeonggi-do 13488 (KR); LEE, Hyeongeun, Seongnam-si, Gyeonggi-do 13488 (KR)
(74) Representative: Mooser, Sebastian Thomas
(86) International application number: PCT/KR2023/001657
(87) International publication number: WO 2023/171916

(57) **Abstract**

The present invention relates to a device between an electron transport layer and a source electrode. A semiconductor organic material having pi - orbital electrons , an organic material containing an element having an unshared electron pair, and an organic material containing at least one organic material having an ionic functional group. The present invention relates to a perovskite solar cell having a transparent conductive oxide layer introduced therein and a method for manufacturing the same.

## Description

### [Technical Field]

The present invention relates to a device between an electron transport layer and a source electrode. A semiconductor organic material having pi - orbital electrons, an organic material containing an element having an unshared electron pair, and an organic material containing at least one organic material having an ionic functional group. The present invention relates to a perovskite solar cell having a transparent conductive oxide layer introduced therein and a method for manufacturing the same.

### [Background Art]

fossil Energy of Exhaustion and dental In use By earth Environmental The problem Solve for Solar energy, wind energy, hydro energy, Same play Possible and clean Alternative To energy source About Korea Research Actively It's in progress there is.
this between sun From the light directly Electrical Energy Changing In solar cells About Korea Interested big Increasing There is. Here. What is a solar cell? from sunlight shed Energy By absorbing With electronics The right hole Occurs Madness The effect By using Current - Voltage To create The battery It means.
today Light energy Conversion efficiency is 20 % Over np diode type Silicon (Si) single crystal Base Solar cell Manufacturing If possible Actual Solar power In development being used , and more than this more Conversion efficiency excellent Gallium arsenide (GaAs) and same compound Semiconductor Used Solar cell map There is . But such weapon semiconductor Based on Solar cells High efficiency For very Highly purified The material Because it is necessary Of raw materials In the refinement many Energy Consumed, and also Raw materials By using Single crystal Or Thin film doing In the process Expensive process The equipment Required Solar cell Manufacturing cost low doing In the day The limit there is For large-scale use stumbling block It has been done.
hereto according to Solar cells At low price To manufacture For that In solar cells To the core Used subject matter Or manufacturing Fairness drastically reduce costs To reduce Need, and weapons semiconductor Base Solar cell As an alternative Low cost Materials and Fairly Manufacturing Possible perovskites In solar cells About Korea Research It's in progress there is.
perovskite solar cells using (NH₃CH₃)PbX₃ (X = I, Br, Cl), a halogen compound with a perovskite structure, as a photoactive agent have been developed, and research is being conducted toward commercialization. The general structural formula of the perovskite structure is the ABX ₃ structure, where an anion is located in the X position, a large cation is located in the A position, and a small cation is located in the B position.

Perovskite solar cells, which are organometallic halide compounds with the molecular formula (CH₃NH₃)PbX₃ , were first used as a photoactive material in solar cells in 2009. Since then, rapid efficiency improvements have been made since the development of solid-state perovskite solar cells with the current structure in 2012. Conventional perovskite solar cells use metal oxides as electron transport layers and mainly use organic or polymeric materials such as spiro-OMETAD as hole transport layers (HTL). That is, a porous film or thin film of metal oxide is fabricated on a transparent electrode such as FTO, a perovskite material is coated, and after the hole transport layer is coated, an electrode layer such as gold (Au) or silver (Ag) is deposited.

Perovskite solar cells, which are organometallic halide compounds with the molecular formula (CH₃NH₃)PbX₃ , use halide ions such as I, Br, and Cl in the molecular formula , and When the surplus halide that does not participate in the formation of the perovskite crystal phase exists in the form of ionic defects, it is not fixed to the perovskite crystal, but can escape from the crystal in the form of halide combined with hydrogen or light cations, thus exhibiting high diffusivity. Therefore, after the fabrication of the Si/perovskite tandem device, the halide ion easily diffuses into the surrounding layers without restriction due to heating, light irradiation, or electrical external factors that are essential in the subsequent module process.

In particular, when it diffuses into an electrode layer such as gold (Au) or silver (Ag) in a Si/perovskite tandem solar cell, it not only corrodes the interface between the transparent electrode and the metal, increasing the interfacial contact resistance, but also causes the metal ion leakage into the solar cell device due to the corrosion of the metal electrode, thereby reducing the performance of the solar cell device.

### [Disclosure]

### [Technical Problem]

The present invention has been devised to overcome the above-described problem, and comprises a layer between the electron transport layer and the source electrode. A semiconductor organic material having pi -orbital electrons, an organic material containing an element having an unshared electron pair, and an organic material containing at least one organic material having an ionic functional group. By introducing a transparent conductive oxide layer, the optical transmittance characteristics for wavelengths of 350 to 1200 nm are not significantly changed. The surface resistance also does not change significantly, The present invention aims to provide a perovskite solar cell and a method for manufacturing the same, which can minimize performance degradation of the perovskite solar cell and ensure stability.

### [Technical Solution]

In order to solve the above-described problem, the perovskite solar cell of the present invention includes a laminate in which a hole transport layer, a perovskite light-absorbing layer, an electron transporting layer, and a source electrode are sequentially laminated.

As a preferred embodiment of the present invention, a transparent conductive oxide layer may be formed between the source electrode and the electron transport layer.

As a preferred embodiment of the present invention, The transparent conductive oxide layer may include at least one of a semiconducting organic material having pi -orbital electrons, an organic material including an element having an unshared electron pair, and an organic material having an ionic functional group.

As a preferred embodiment of the present invention, The transparent conductive oxide layer may have a structure in which a first transparent conductive oxide layer, a functional organic material layer, and a second transparent conductive oxide layer are sequentially laminated.

As a preferred embodiment of the present invention, The first transparent conductive oxide layer may be a transparent thin film deposited with indium tin oxide (ITO), fluorine doped tin oxide (FTO), Sb₂O₃ doped tin oxide (ATO), gallium doped tin oxide (GTO), tin doped zinc oxide (ZTO), ZTO:Ga (gallium doped ZTO), indium gallium zinc oxide (IGZO), indium doped zinc oxide (IZO), or aluminum doped zinc oxide (AZO) .

As a preferred embodiment of the present invention, The second transparent conductive oxide layer may be a transparent thin film deposited with indium tin oxide (ITO), fluorine doped tin oxide (FTO), Sb ₂O₃ doped tin oxide (ATO), gallium doped tin oxide (GTO), tin doped zinc oxide (ZTO), ZTO:Ga (gallium doped ZTO), indium gallium zinc oxide (IGZO), indium doped zinc oxide (IZO), or aluminum doped zinc oxide (AZO) .

As a preferred embodiment of the present invention, The functional organic material layer can be a thin film deposited with a semiconducting organic material having pi-orbital electrons, an organic material including an element having a lone electron pair, or an organic material having an ionic functional group.

As a preferred embodiment of the present invention, The semiconductor organic material having pi -orbital electrons may include at least one selected from fullerene, fullerene-based derivatives, perylene diimide (PDI), and naphthalene diimide (NDI).

As a preferred embodiment of the present invention, Organic substances containing elements with unshared electron pairs include oxygen, It may be an organic substance containing one or more elements selected from nitrogen and phosphorus.

As a preferred embodiment of the present invention, The organic material having an ionic functional group may include at least one selected from polyethylenimine ethoxylated (PEIE) and poly[(9,9-di(3,3'-N,N'-trimethylammonium)propylfluorenyl-2,7-diyl)-alt-co-(9,9-dioctylfluorenyl-2,7-diyl)] diiodide salt ( PFN ).

As a preferred embodiment of the present invention, The first transparent conductive oxide layer and the functional organic material layer can have a thickness ratio of 1: 0.05 to 0.15.

As a preferred embodiment of the present invention, The second transparent conductive oxide layer and the functional organic material layer can have a thickness ratio of 1: 0.05 to 0.15.

As a preferred embodiment of the present invention, The first transparent conductive oxide layer can have an average thickness of 5 to 100 nm.

As a preferred embodiment of the present invention, The functional organic material layer can have an average thickness of 2 to 50 nm.

As a preferred embodiment of the present invention, The second transparent conductive oxide layer can have an average thickness of 5 to 100 nm.

As a preferred embodiment of the present invention, The perovskite solar cell of the present invention may be a p -in structure perovskite solar cell, a nip inverted structure perovskite solar cell, a tandem perovskite solar cell, or a tandem silicon/perovskite heterojunction solar cell.

As a preferred embodiment of the present invention, The transparent conductive oxide layer has a light transmittance of 70 to 99% for wavelengths of 350 to 1200 nm. The surface resistance can be 5 to 500 Ω /sq.
one side, The method for manufacturing a perovskite solar cell of the present invention comprises a first step of forming a transparent conductive oxide layer through a deposition process on an electron transport layer of a laminate in which a hole transport layer, a perovskite light-absorbing layer, and an electron transport layer are sequentially laminated, and a second step of forming a source electrode on the transparent conductive oxide layer . The above transparent conductive oxide layer may include at least one of a semiconducting organic material having pi -orbital electrons, an organic material including an element having an unshared electron pair, and an organic material having an ionic functional group.

As a preferred embodiment of the present invention, The above first step is a 1-1 step of forming a first transparent conductive oxide layer on top of the electron transport layer of a laminate in which a hole transport layer, a perovskite light absorbing layer, and an electron transport layer are sequentially laminated through a deposition process. Step 1-2 of forming a functional organic material layer on top of the first transparent conductive oxide layer through a deposition or solution process And it may include steps 1 to 3 of forming a second transparent conductive oxide layer through a deposition process on the functional organic material layer.
one side, The tandem silicon/perovskite heterojunction solar cell of the present invention comprises a drain electrode, a silicon solar cell, a recombination layer, a hole transport layer, a perovskite light-absorbing layer, an electron transport layer, and a source electrode sequentially laminated. A laminate is included, and a transparent conductive oxide layer is formed between the source electrode and the electron transport layer, wherein the transparent conductive oxide layer may include at least one of a semiconducting organic material having pi -orbital electrons, an organic material including an element having an unshared electron pair, and an organic material having an ionic functional group.

### [Advantageous Effects]

The perovskite solar cell of the present invention comprises an electron transport layer between the source electrode and the A semiconductor organic material having pi -orbital electrons, an organic material containing an element having an unshared electron pair, and an organic material containing at least one organic material having an ionic functional group. By introducing a transparent conductive oxide layer, The lifespan can be increased by preventing the diffusion of halide anions in the perovskite light-absorbing layer to the source electrode interface of the metal material and the resulting corrosion phenomenon, also, The anti-reflection properties can be adjusted by changing the optical properties. It can improve performance.

### [Brief description of the drawing]

FIG. 1 is a cross-sectional view illustrating a transparent conductive oxide layer according to a preferred embodiment of the present invention.
Figure 2 is a graph measuring the light transmittance of each of the transparent conductive oxide films manufactured in Preparation Example 1, Preparation Example 2, and Comparative Preparation Example 1.

### [Modes of the Invention]

Hereinafter, the present invention will be described in more detail.

Existing perovskite solar cells have a problem in that halide anions diffusing from the perovskite light-absorbing layer corrode the interface of the metal source electrode, which increases the interfacial contact resistance, and also causes metal ions to leak into the perovskite solar cell due to the corrosion of the metal source electrode, which reduces the performance of the perovskite solar cell.

Accordingly, the present invention provides a device between an electron transport layer and a source electrode. A semiconductor organic material having pi -orbital electrons, an organic material containing an element having an unshared electron pair, and an organic material containing at least one organic material having an ionic functional group. By introducing a transparent conductive oxide layer, By preventing the halide anions diffusing in the perovskite light-absorbing layer from diffusion to the source electrode interface of the metal material and the resulting corrosion phenomenon, the lifespan is increased. By changing the optical properties, it has anti-reflection properties. It is about perovskite solar cells with improved performance.

The perovskite solar cell of the present invention may be a pin structure type perovskite solar cell, a nip inverted structure type perovskite solar cell, a tandem type perovskite solar cell, or a tandem type silicon/perovskite heterojunction solar cell. Preferably, it may be a tandem silicon/perovskite heterojunction solar cell, Hole transport layer ( HTL, or hole transport layer ) perovskite light absorbing layer, Electron transport layer ( ETL ), transparent conductive oxide layer and A solar cell including a laminated structure in which source electrodes are sequentially laminated.

For example, a desirable implementation would be: If the perovskite solar cell of the present invention is a tandem silicon/perovskite heterojunction solar cell, Drain electrode, silicon solar cell, The recombinant layer and the laminate may include a structure in which the laminate is sequentially laminated. Specifically, In the case of tandem silicon/perovskite heterojunction solar cells, Drain electrode, silicon solar cell, It may include a structure in which a recombination layer, a hole transport layer, a perovskite light-absorbing layer, an electron transport layer, a transparent conductive oxide layer, and a source electrode are sequentially laminated.

The hole transport layer ( HTL) may include inorganic and/or organic hole transport materials.

At this time, the inorganic hole transport materials are nickel oxide (NiOx), MoOx, CuSCN, CuCrO₂, CuI, MoO, and V₂O₅. It may include one or more selected from among :
also, The organic hole transport material is carbazole Derivatives , polyaryl alkane Derivative , phenylenediamine Derivatives , arylamines Derivatives , amino substitution Calcon Derivative , styrylanthracene Derivative , fluorene Derivatives , hydrazones Derivatives , stilbene derivatives , silazane Derivatives , Aromatic 3rd class Amin Compound , styrylamine compound , aromatic Dimethylidine series Compound , porphyrin Compound , phthalocyanine series Compound , polythiophene Derivatives , polypyrrole Derivative , polyparaphenylene vinylene Derivatives, pentacene , coumarin 6, 3-(2-benzothiazolyl)-7-(diethylamino)coumarin), ZnPC (zinc phthalocyanine), CuPC (copper phthalocyanine), TiOPC (titanium oxide phthalocyanine), Spiro-MeOTAD(2,2',7,7'-tetrakis(N,Np-dimethoxyphenylamino)-9,9'-spirobifluorene), F16CuPC(copper(II) 1,2,3,4,8,9,10,11,15,16,17,18,22,23,24,25-hexadecafluoro-29H,31H-phthalocyanine), SubPc (boron subphthalocyanine chloride) and N3(cis-di(thiocyanato)-bis(2,2'-bipyridyl-4,4'-dicarboxylic acid)-ruthenium(II), P3HT(poly[3-hexylthiophene]), MDMO-PPV(poly[2-methoxy-5-(3',7'-dimethyloctyloxyl)]-1,4-phenylene vinylene), MEH-PPV(poly[2-methoxy-5-(2"-ethylhexyloxy)-p-phenylene vinylene]), P30T(poly(3-octyl thiophene)), POT(poly(octyl thiophene)), P3DT(poly(3-decyl thiophene)), P3DDT(poly(3-dodecyl thiophene), PPV(poly(p-phenylene vinylene)), TFB(poly(9,9'-dioctylfluorene-co-N-(4-butylphenyl)diphenyl amine), Polyaniline , Spiro-MeOTAD ([2,22' ,7,77' -tetrkis (N,N-di-pmethoxyphenyl amine)-9,9,9'-spirobi fluorine]), PCPDTBT(Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT(poly[(4,4 ' -bis(2-ethylhexyl)dithieno[3,2-b:2'),3 ' -d]silole)-2,6- diyl-alt-(2,1,3-benzothiadiazole)-4,7-diyl]), PBDTTPD(poly((4,8-diethylhexyloxyl), PFDTBT(poly[2,7-(9-(2-ethylhexyl)-9-hexyl-fluorene)-alt-5,5-(4', 7, -di-2-thienyl-2',1', 3'-benzothiadiazole)]), PFO-DBT(poly[2,7-.9,9-(dioctyl-fluorene)-alt-5,5-(4',7'-di-2-.thienyl-2', 1', 3'-benzothiadiazole)]), PSiFDTBT(poly[(2,7-dioctylsilafluorene)-2,7-diyl-alt-(4,7-bis(2-thienyl)-2,1,3-benzothiadiazole)-5,5' -diyl]), PCDTBT(Poly[[9-(1-octylnonyl)-9H-carbazole-2,7-diyl] -2,5-thiophenediyl-2,1,3-benzothiadiazole-4,7-diyl-2,5-thiophenediyl]), PFB(poly(9,9 ' -dioctylfluorene-co-bis(N,N'-(4,butylphenyl))bis(N,N ' -phenyl-1,4-phenylene)diamine), F8BT(poly(9,9') -dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, 4-PACz, MeO-2PACz, Br-2PACz, Me-4PACz, It may include one or more types selected from MeO-4PACz and 6-PACz .
also, The positive hole transport layer forming By way of Application method , and vacuum Deposition method Back field number There is, By application method Gravure Application method , bar Application method , printing method , spray method , spin method Coating method , dipping method and die Coat law Back field number There is, Vacuum deposition methods include thermal deposition, E-beam deposition, sputter deposition, and ALD deposition .

The perovskite light-absorbing layer may include a general perovskite material applied to the light-absorbing layer of a solar cell. A desirable example would be: It may include a perovskite material represented by the following chemical formula 1 .

[Chemical Formula 1] CMX₃

the above chemical formula 1, C is a monovalent cation, amine , ammonium , group 1 Metal , Group 2 metal , and / or different Cation or Cation - pseudo may contain compounds, Preferably formamidinium (FA, formamidinium) , methylammonium (MA, methylammonium), FAMA, CsFAMA, CsFA or N(R)⁴⁺ ( wherein, R may be the same or different groups, and R is a straight-chain alkyl group having 1 to 5 carbon atoms , A pulverized alkyl group having 3 to 5 carbon atoms , a phenyl group, Alkylphenyl group, Alkoxyphenyl group or ) may be an alkyl halide.
also, M in chemical formula 1 is a divalent cation, such as Fe, Co, Ni, Cu, Sn, Pb, Bi, Ge, Ti, Eu. and may include one or two kinds selected from Zr .
also, X in chemical formula 1 is a 1 -valent anion, one selected from F, Cl, Br, and I. ideal may contain a halide element and/or a group 16 anion, As a desirable example, X can be Iₓ Br_{3 -x} (0 ≤ x ≤ 3).
and, A preferred embodiment of chemical formula 1 is as follows: FAPbIₓ Br_{3 -x} (0 ≤ x ≤ 3) , MAPbIₓBr₃₋ₓ (0 ≤ x ≤ 3), CSMAFAPbIₓBr₃₋ₓ (0 ≤ x ≤ 3), CH₃ NH₃PbX₃ ( X = Cl, Br, I, BrI₂ , or Br₂I), CH₃NH₃SnX₃ ( X = Cl, Br or I), CH(=NH)NH₃ PbX₃( X = Cl, Br, I, BrI₂ , or Br₂I) or CH(=NH)NH₃SnX₃ (X = Cl, Br or I).
one side, In the perovskite solar cell of the present invention, The perovskite light-absorbing layer may be a single layer composed of the same perovskite material, or may be a multilayer structure in which multiple layers composed of different perovskite materials are stacked. A pillar-shaped structure inside a light-absorbing layer made of a type of perovskite material. plate shape, couch, wire shape, It may also include a heterogeneous perovskite material other than the above one having a pillar shape such as a rod formation.
also, Perovskite light absorbing layer forming By way of Application method , and vacuum Deposition method Back field number There is, By application method Gravure Application method , bar Application method , printing method , spray method , spin method Coating method , dip method, inkjet application method and die Coat law Back field number there is .

The electron transport layer ( ETL ) may include organic and/or inorganic hole transport materials.

At this time, the organic electron transport material may include at least one selected from C ₆₀, C ₇₀, PC60BM, PC70BM, BCP, and PEIE .

Additionally, the inorganic electron transport material may include one or more semiconductor metal oxides such as titanium oxide (TiO2), SnO, and ZnO.

In addition, methods for forming the electron transport layer include vacuum deposition and solution coating, and vacuum deposition methods include thermal deposition, E-beam deposition, sputter deposition, and ALD deposition, and solution coating methods include gravure coating, bar coating, printing, spraying, spin coating, dip coating, and die coating.

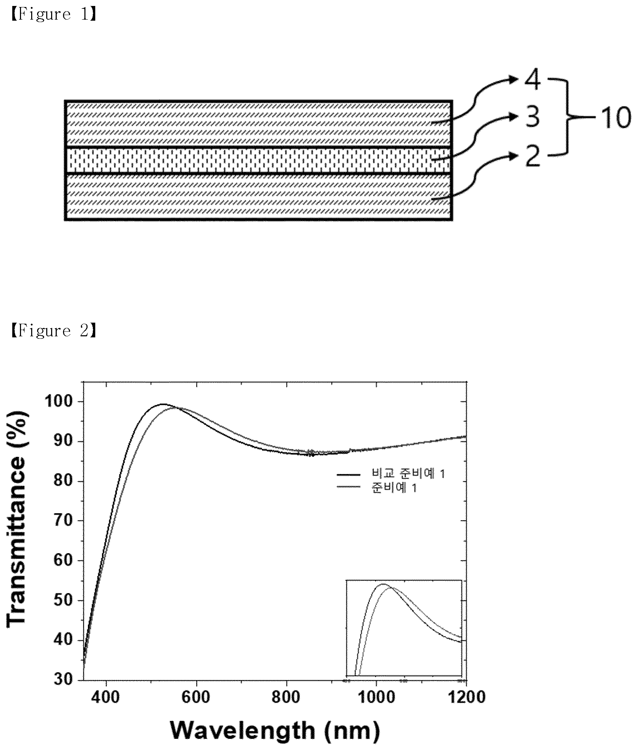

Referring to Figure 1 , A transparent conductive oxide layer (10) can be formed on top of the electron transport layer through a deposition process or a solution process.

At this time, Deposition can be performed using a common deposition process used in the art. Preferably, a vacuum deposition process can be performed, also, The solution process can be performed through a spin coating process.

In addition, the transparent conductive oxide layer (10) may include at least one of a semiconducting organic material having pi-orbital electrons , an organic material including an element having an unshared electron pair , and an organic material having an ionic functional group .

Specifically, The transparent conductive oxide layer (10) may have a structure in which a first transparent conductive oxide layer (2), a functional organic material layer (3), and a second transparent conductive oxide layer (4) are sequentially laminated. Preferably, an organic material capable of lowering surface energy when a second transparent conductive oxide layer (4) is deposited on a functional organic material layer (3), Specifically, It may include at least one selected from a semiconductor organic material having pi -orbital electrons , an organic material including an element having a lone pair of electrons , and an organic material having an ionic functional group . In other words, The transparent conductive oxide layer (10) is formed by a first transparent conductive oxide layer (2) through a deposition process on top of the electron transport layer , A functional organic material layer (3) is formed on top of the first transparent conductive oxide layer (2) through a deposition or solution process, By forming a second transparent conductive oxide layer ( 4) through a deposition process on top of the functional organic material layer (3) , a structure can be formed in which the first transparent conductive oxide layer (2), the functional organic material layer ( 3), and the second transparent conductive oxide layer (4) are sequentially laminated.
one side, The first transparent conductive oxide layer (2) may be a transparent thin film on which ITO (Indium Tin Oxide), FTO (Fluorine doped Tin Oxide), ATO (Sb₂O₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide), or AZO (Aluminum doped zinc oxide) is deposited .
also, The second transparent conductive oxide layer (4) may be a transparent thin film on which ITO (Indium Tin Oxide), FTO (Fluorine doped Tin Oxide), ATO (Sb ₂O₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide), or AZO (Aluminum doped zinc oxide) is deposited .
also, The functional organic material layer (3) may be a thin film on which a semiconductor organic material having pi-orbital electrons , an organic material including an element having an unshared electron pair , or an organic material having an ionic functional group is deposited.

At this time, the semiconductor organic material having pi-orbital electrons may include at least one selected from fullerene, fullerene-based derivatives, perylene diimide (PDI), and naphthalene diimide (NDI). As a concrete example, The fullerene may _{include} at least one selected from C ₆₀ fullerene and C ₇₀ fullerene , Fullerene-based derivatives may include PCBM (Phenyl-C61-butyric acid methyl ester) .
also, Organic substances containing elements with unshared electron pairs include oxygen, It may be an organic substance containing one or more elements selected from nitrogen and phosphorus . As a concrete example, The organic material containing an element having a lone pair of electrons may include at least one selected from crown ether and porphyrin series derivatives .

In addition, the semiconductor organic material having an ionic functional group may include a depositable organic material that can exist in the form of a salt, Preferably, it may include at least one selected from PEIE (polyethylenimine ethoxylated) and PFN (Poly[(9,9-di(3,3'-N,N'-trimethylammonium)propylfluorenyl-2,7-diyl)-alt-co-(9,9-dioctylfluorenyl-2,7-diyl)] diiodide salt ) .

Specifically, The first transparent conductive oxide layer (2) and the functional organic material layer (3) may have a thickness ratio of 1: 0.05 to 0.15 , preferably a thickness ratio of 1:0.066 to 0.1 , and more preferably a thickness ratio of 1:0.075 to 0.092 . Even more preferably, it can have a thickness ratio of 1:0.079 to 0.088 , If the thickness ratio is less than 1:0.05 , there may be a problem in protecting the electrode, and if it exceeds 1:0.15 , there may be a problem in which the performance of the solar cell deteriorates due to increased internal resistance.

In addition, the second transparent conductive oxide layer (4) and the functional organic material layer (3) may have a thickness ratio of 1: 0.05 to 0.15 , preferably a thickness ratio of 1:0.066 to 0.1 , and more preferably a thickness ratio of 1:0.075 to 0.092 . Even more preferably, it can have a thickness ratio of 1:0.079 to 0.088 , If the thickness ratio is less than 1:0.05 , there may be a problem in protecting the electrode , and if it exceeds 1:0.15 , there may be a problem in which the performance of the solar cell deteriorates due to increased internal resistance.
one side, The first transparent conductive oxide layer (2) may have an average thickness of 5 to 100 nm, preferably 20 to 80 nm, more preferably 30 to 70 nm . If the average thickness is less than 5 nm , there may be a problem of reduced performance of the solar cell due to increased internal resistance, and if it exceeds 100 nm , there may be a problem of reduced light transmittance at long wavelengths.
also, The second transparent conductive oxide layer (4) may have an average thickness of 5 to 100 nm, preferably 20 to 80 nm, more preferably 30 to 70 nm . If the average thickness is less than 5 nm , there may be a problem of reduced performance of the solar cell due to increased internal resistance, and if it exceeds 100 nm , there may be a problem of reduced light transmittance at long wavelengths.
also, The functional organic material layer is 2 to 50 nm, preferably 2 to 15 nm, or more . It may preferably have an average thickness of 3 to 11 nm, more preferably 4 to 9 nm, and most preferably 4 to 7 nm . If the average thickness is less than 2 nm , there may be a problem in protecting the electrode, and if it exceeds 50 nm , there may be a problem in which the performance of the solar cell deteriorates due to increased internal resistance.

The source electrode can be formed on top of a transparent conductive oxide layer through a coating or deposition process . also, The source electrodes are Pt, Au, Ni, Cu, Ag, In, Ru, Pd, Rh, Ir, Os, C and conductivity One selected from polymers It may include the following:
also, The solar cell of the present invention comprises the light absorption layer and the electron transport layer. An additional passivation layer may be included in between .

The drain electrode is a conductive metal, alloy of conductive metals, It can be manufactured from a material including at least one selected from metal oxides and conductive polymers . Preferred examples include ITO (Indium Tin Oxide), FTO (Fluorine doped Tin Oxide), ATO (Sb ₂ O ₃ doped Tin Oxide), GTO ( Gallium doped Tin Oxide), ZTO (tin doped zinc oxide ), It may include ZTO:Ga (gallium doped ZTO), IGZO (Indium gallium zinc oxide ), IZO (Indium doped zinc oxide ) , and/or AZO ( Aluminum doped zinc oxide ) .
one side, The method for manufacturing a perovskite solar cell of the present invention may include a first step of forming a transparent conductive oxide layer through a deposition process on an electron transport layer of a laminate in which a hole transport layer , a perovskite light - absorbing layer , and an electron transport layer are sequentially laminated, and a second step of forming a source electrode on the transparent conductive oxide layer . The transparent conductive oxide layer may include at least one of a semiconducting organic material having pi -orbital electrons , an organic material including an element having an unshared electron pair , and an organic material having an ionic functional group .

Specifically, The first step of the method for manufacturing a perovskite solar cell of the present invention comprises: a first step of forming a first transparent conductive oxide layer through a deposition process on an electron transport layer of a laminate in which a hole transport layer , a perovskite light-absorbing layer, and an electron transport layer are sequentially laminated; and a first step of forming a functional organic material layer through a deposition or solution process on the first transparent conductive oxide layer . and may include a step 1-3 of forming a first transparent conductive oxide layer through a deposition process on the functional organic material layer . The specific description of each floor is as explained above.

Hereinafter, the present invention will be described more specifically through examples; however, the following examples do not limit the scope of the present invention, and should be interpreted as helping to understand the present invention.

### Preparation 1 : Fabrication of transparent conductive oxide films

A washed bare glass substrate was prepared, and IZO (Indium doped zinc oxide) was deposited on the upper part of the glass substrate through a sputtering process to form a first transparent conductive oxide layer with an average thickness of 60 nm .

Next , vacuum deposition Through the process, C 60 _{fullerene} was deposited on top of the first transparent conductive oxide layer to form a functional _{organic} material layer with an average thickness of 5 nm .

Next , IZO (Indium doped zinc oxide) was deposited on top of the functional organic material layer through a sputtering process to form a second transparent conductive oxide layer with an average thickness of 60 nm , thereby manufacturing a transparent conductive oxide film.

### Comparison Preparation Example 1 : Fabrication of transparent conductive oxide films

A washed bare glass substrate was prepared, and IZO (Indium doped zinc oxide) was deposited on the upper part of the glass substrate through a sputtering process to form a transparent conductive oxide film with an average thickness of 120 nm .

### Experimental Example 1: Surface resistance and Light transmittance measurement

In order to confirm the electrical and optical properties of the transparent conductive oxide film manufactured in Preparation Example 1 and Comparative Preparation Example 1 , bare glass After laminating the transparent conductive oxide films manufactured in Preparation Example 1 and Comparative Preparation Example 1 on one side, the light transmittance in the range of 350 nm to 1200 nm (Fig. 2) was measured using UV-Vis spectroscopy , and the sheet resistance of the transparent conductive oxide films was measured using the 4-point probe method , and the results are shown in Table 1 below.

**[Table 1]**

| division | Surface resistance (Ω /sq) | Light Transmittance (%) |
|---|---|---|
| Preparation Example 1 | 37.71 | 89. 11 |
| Comparison Preparation Example 1 | 41.83 | 89.54 |

As can be seen in Table 1 , It can be confirmed that the transparent conductive oxide film manufactured in Preparation Example 1 and the transparent conductive oxide film manufactured in Comparative Preparation Example 1 show similar surface resistance and light transmittance. Through this, even if the transparent conductive oxide film manufactured in Preparation Example 1 is used in a solar cell that generally uses the transparent conductive oxide film manufactured in Comparative Preparation Example 1 , It was confirmed that the electrical and optical characteristics were similar and did not deteriorate the performance of the solar cell.

### Example 1 : Fabrication of tandem silicon/perovskite heterojunction solar cells

As a lower solar cell, a silicon solar cell doped with n or p type impurities was treated with hydrofluoric acid to remove the SiOx oxide film, and then the remaining hydrofluoric acid was removed using ultrapure water. A thin recombination layer was formed on the top of the silicon solar cell from which the oxide film was removed through a sputtering process.

Next , a 30 nm thick hole transport layer (NiOx/ organic material ) was formed on the silicon solar cell through an E-beam vacuum deposition process and a spin coating process .

Next , a yellow light-absorbing layer solution dissolved in dimethylformamide (DMF) and dimethyl sulfoxide (DMSO) was formed by spin coating on the hole transport layer, and heat-treated at 100° C for 20 minutes to form a NiOx hole transport layer and a perovskite light-absorbing layer ( CSMAFAPbI x _{Br} 3 ₋ₓ (0 ≤ x ≤ 3)) having a perovskite crystal structure with a thickness of 450 to 900 nm.

Next , C60 fullerene is deposited on top of the perovskite light-absorbing layer _{through} vacuum deposition . On top of the perovskite light-absorbing layer, C60 fullerene was deposited through the ALD ( atomic layer deposition) process . An electron transport layer with an average thickness of 20 nm was formed by depositing S nO ₓ .

Next , IZO (Indium doped zinc oxide) was deposited on top of the electron transport layer through a sputtering process to form a first transparent conductive oxide layer with an average thickness of 60 nm .

Next , C ₆₀ fullerene was deposited on top of the first transparent conductive oxide layer through a vacuum deposition process to form a functional organic material layer with an average thickness of 5 nm .

Next , IZO (Indium doped zinc oxide) was deposited on top of the functional organic material layer through a sputtering process to form a second transparent conductive oxide layer with an average thickness of 60 nm .

Next , silver (Ag) is deposited on the second transparent conductive oxide layer at a pressure of 1×10 -7 ^{torr} with a thickness of 100 nm to form a source electrode, thereby forming a silicon solar cell-recombination layer-hole transport layer- perovskite light-absorbing layer-electron transport layer- A tandem silicon/perovskite heterojunction solar cell was manufactured in the form of a first transparent conductive oxide layer , a functional organic material layer , a second transparent conductive oxide layer, and a source electrode laminated in that order .

### Example 2 : Fabrication of tandem silicon/perovskite heterojunction solar cells

A tandem silicon/perovskite heterojunction solar cell was manufactured using the same method as in Example 1. However, Unlike Example 1 , Functional organic material layer is spin coated Through the process, polyethylenimine ethoxylated (PEIE ) is deposited on top of the first transparent conductive oxide layer. By depositing and forming it with an average thickness of 5 nm , Finally, a tandem silicon/perovskite heterojunction solar cell was fabricated.

### Comparative example 1 : Fabrication of tandem silicon/perovskite heterojunction solar cells

As a lower solar cell, a silicon solar cell doped with n or p type impurities was treated with hydrofluoric acid to remove the SiOx oxide film, and then the remaining hydrofluoric acid was removed using ultrapure water. A thin recombination layer was formed on the top of the silicon solar cell from which the oxide film was removed through a sputtering process.

Next , a 30 nm thick hole transport layer (NiOx/ organic material ) was formed on the silicon solar cell through an E-beam vacuum deposition process and a spin coating process .

Next , a yellow light-absorbing layer solution dissolved in dimethylformamide (DMF) and dimethyl sulfoxide (DMSO) was formed by spin coating on the hole transport layer, and heat-treated at 100° C for 20 minutes to form a NiOx hole transport layer and a perovskite light-absorbing layer ( CSMAFAPbI x _{Br} 3 ₋ₓ (0 ≤ x ≤ 3)) having a perovskite crystal structure with a thickness of 450 to 900 nm.

Next , C60 fullerene is deposited on top of the perovskite light-absorbing layer _{through} vacuum deposition . On top of the perovskite light-absorbing layer, C60 fullerene was deposited through the ALD ( atomic layer deposition) process . An electron transport layer with an average thickness of 20 nm was formed by depositing S nO ₓ .

Next , IZO (Indium doped zinc oxide) was deposited on top of the electron transport layer through a sputtering process to form a transparent conductive oxide layer with an average thickness of 120 nm .

Next , silver (Ag) was deposited on the transparent conductive oxide layer at a pressure of 1×10 ⁻⁷ torr to a thickness of 100 nm to form a source electrode, thereby manufacturing a tandem silicon/perovskite heterojunction solar cell in the form of a silicon solar cell-recombination layer-hole transport layer- perovskite light-absorbing layer-electron transport layer-transparent conductive oxide layer-source electrode laminated in that order .

### Experimental example 2: Measurement of performance and long-term storage stability of solar cells

For each of the tandem silicon/perovskite heterojunction solar cells manufactured in Examples 1, 2 and Comparative Example 1 , Using solar simulation equipment and JV Keithley equipment , the efficiency was measured using the initial JV curve, and then the aging was measured by storing it in a desiccator for 14 days. After The changes in solar cell characteristics were measured and are shown in Table 2 below.

**[Table 2]**

| divisi on | aging time (day ) | Open circuit voltage (V_{oc}, V) | Short circuit current density (J_{sc}, mA/cm²) | Phil Factor (FF) | Photoelectri c conversion efficiency (%) | Decrea se rate (%) |
|---|---|---|---|---|---|---|
| Exampl e 1 | 1 | 1.844 | 18.81 | 76.72 | 26.61 | -10.3 |
| | 14 | 1.827 | 19.01 | 68.75 | 23.87 | |
| Exampl e 2 | 1 | 1.834 | 19.36 | 75.48 | 26.8 | 0.04 |
| | 14 | 1.849 | 19.58 | 74.08 | 26.81 | |
| Compar ative Exampl e 1 | 1 | 1.842 | 19.44 | 74.07 | 26.53 | -17.94 |
| | 14 | 1.813 | 19.56 | 61.37 | 21.77 | |

As can be seen in Table 2 above, It was confirmed that the tandem silicon/perovskite heterojunction solar cell manufactured in Examples 1 and 2 had higher long-term storage stability than the tandem silicon/perovskite heterojunction solar cell manufactured in Comparative Example 1 .

The above has been illustrated and described with respect to specific embodiments. However, it is not limited to the above-described embodiments, and those skilled in the art to which the invention pertains can make various modifications and implementations without departing from the gist of the technical idea of the invention described in the claims below.

## Claims

1. It includes a laminate in which a hole transport layer, a perovskite light absorbing layer, an electron transport layer, and a source electrode are sequentially laminated.
A transparent conductive oxide layer is formed between the source electrode and the electron transport layer,
perovskite solar cell, **characterized in that** the transparent conductive oxide layer includes at least one of a semiconducting organic material having pi - orbital electrons, an organic material including an element having an unshared electron pair, and an organic material having an ionic functional group.

2. In the first paragraph,
A perovskite solar cell **characterized in that** the transparent conductive oxide layer has a structure in which a first transparent conductive oxide layer, a functional organic material layer, and a second transparent conductive oxide layer are sequentially laminated.

3. In the second paragraph,
first transparent conductive oxide layer and the second transparent conductive oxide layer is a transparent thin film on which ITO (Indium Tin Oxide), FTO (Fluorine doped Tin Oxide), ATO (Sb ₂O₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide), or AZO (Aluminum doped zinc oxide) is deposited .
The above functional organic material layer is a thin film on which a semiconductor organic material having pi-orbital electrons, an organic material including an element having an unshared electron pair, or an organic material having an ionic functional group is deposited.
The semiconductor organic material having the above pi -orbital electrons includes at least one selected from fullerene, fullerene-based derivatives, perylene diimide (PDI), and naphthalene diimide (NDI).
Organic substances containing elements having the above unshared electron pairs include oxygen, An organic substance containing one or more elements selected from nitrogen and phosphorus.
A perovskite solar cell **characterized in that** the organic material having the above ionic functional group includes at least one selected from polyethylenimine ethoxylated (PEIE) and poly [ (9,9-di(3,3'- N,N '-trimethylammonium)propylfluorenyl- 2,7 -diyl)-alt- co- (9,9-dioctylfluorenyl-2,7-diyl)] diiodide salt (PFN).

4. In the second paragraph,
The first transparent conductive oxide layer and the functional organic material layer have a thickness ratio of 1: 0.05 to 0.15,
A perovskite solar cell, **characterized in that** the second transparent conductive oxide layer and the functional organic material layer have a thickness ratio of 1: 0.05 to 0.15.

5. In the second paragraph,
Each of the first transparent conductive oxide layer and the second transparent conductive oxide layer has an average thickness of 5 to 100 nm,
Above A perovskite solar cell **characterized in that** the functional organic material layer has an average thickness of 2 to 50 nm.

6. In any one of claims 1 to 5,
A perovskite solar cell **characterized in that** the above perovskite solar cell is a pin structure type perovskite solar cell, a nip inverted structure type perovskite solar cell, a tandem perovskite solar cell, or a tandem silicon/perovskite heterojunction solar cell.

7. In paragraph 6,
The above transparent conductive oxide layer has a light transmittance of 70 to 99% for a wavelength of 350 to 1200 nm, A perovskite solar cell **characterized by** a surface resistance of 5 to 500 Ω /sq.

8. A first step of forming a transparent conductive oxide layer through a deposition process on the electron transport layer of a laminate in which a hole transport layer , a perovskite light absorbing layer, and an electron transport layer are sequentially laminated ; and
A second step of forming a source electrode on top of the transparent conductive oxide layer ; Including,
a perovskite solar cell, wherein the transparent conductive oxide layer comprises at least one of a semiconducting organic material having pi - orbital electrons , an organic material including an element having an unshared electron pair, and an organic material having an ionic functional group .

9. In Article 8, The above first step is
1-1 of forming a first transparent conductive oxide layer on top of an electron transport layer of a laminate in which a hole transport layer , a perovskite light-absorbing layer, and an electron transport layer are sequentially laminated through a deposition process ;
1-2 of forming a functional organic material layer on top of the first transparent conductive oxide layer through a deposition or solution process; and
1-3 of forming a second transparent conductive oxide layer through a deposition process on top of the functional organic material layer ;
A method for manufacturing a perovskite solar cell, **characterized by** including a .

10. A drain electrode, a silicon solar cell, a recombination layer, a hole transport layer, a perovskite light absorbing layer, an electron transport layer, and a source electrode are sequentially stacked. Contains a laminate,
A transparent conductive oxide layer is formed between the source electrode and the electron transport layer ,
tandem silicon/perovskite heterojunction solar cell, **characterized in that** the transparent conductive oxide layer includes at least one of a semiconducting organic material having pi -orbital electrons , an organic material including an element having an unshared electron pair, and an organic material having an ionic functional group .
